# FASCICULE DE BREVET EUROPEEN

(11) **EP 1 187 206 B1**
(45) Date de publication et mention de la délivrance du brevet: **09.12.2009**
(21) Numéro de dépôt: 01203251.2
(22) Date de dépôt: 28.08.2001
(51) Int. Cl.: H01L 23/552, H05K 9/00

(54) **Dispositif intégré de protection électromagnétique**
Integrierte elektromagnetische Abschirmvorrichtung
Integrated electromagnetic protection device

(30) Priorité: 05.09.2000 FR 0011307
(43) Date de publication de la demande: 13.03.2002
(73) Titulaire: NXP B.V., 5656 AG Eindhoven (NL)
(72) Inventeur: Gamand, Patrice, Société Civile S.P.I.D, 75008 Paris (FR); de la Torre Alain, Société Civile S.P.I.D, 75008 Paris (FR)
(74) Mandataire: Schouten, Marcus Maria

(56) Documents cités:
- DE-U- 9 214 898
- US-A- 4 954 929
- US-A- 5 151 770
- US-A- 5 831 324
- US-A- 6 075 700

## Description

### DOMAINE TECHNIQUE

La présente invention concerne l'isolation de signaux électriques qui se propagent dans des connexions formées sur des substrats semiconducteurs ou qui sont engendrés dans des circuits intégrés ou des éléments de tels circuits.

### ETAT DE LA TECHNIQUE ANTERIEURE

On connaît des dispositifs électroniques, par exemple des circuits émetteurs-récepteurs intégrés, dans lesquels coexistent différents types de signaux. Ces derniers peuvent différer par leurs fréquences ou par la nature des informations qu'ils propagent : certains des signaux peuvent être logiques tandis que d'autres sont analogiques.

La coexistence de ces divers signaux perturbe le fonctionnement des circuits. A titre d'exemple, un signal numérique, tel qu'un signal d'horloge, est susceptible d'interférer avec un signal analogique.

De plus, l'intégration d'éléments inductifs dans ces circuits engendre un couplage électromagnétique entre ces éléments inductifs et des connexions électriques où se propagent d'autres signaux.

Ainsi, dans un récepteur intégré, la qualité spectrale des fréquences engendrées par des oscillateurs commandés en tension risque d'être perturbée par les commutations de signaux d'horloge.

Dans un dispositif électronique, il est donc nécessaire d'isoler efficacement les connexions électriques dans lesquelles se propagent des signaux susceptibles de perturber le fonctionnement du dispositif

Une manière connue de résoudre partiellement ce problème consiste à insérer une connexion perturbatrice entre deux lignes conductrices et à connecter ces dernières à la masse ou à une source de tension continue.

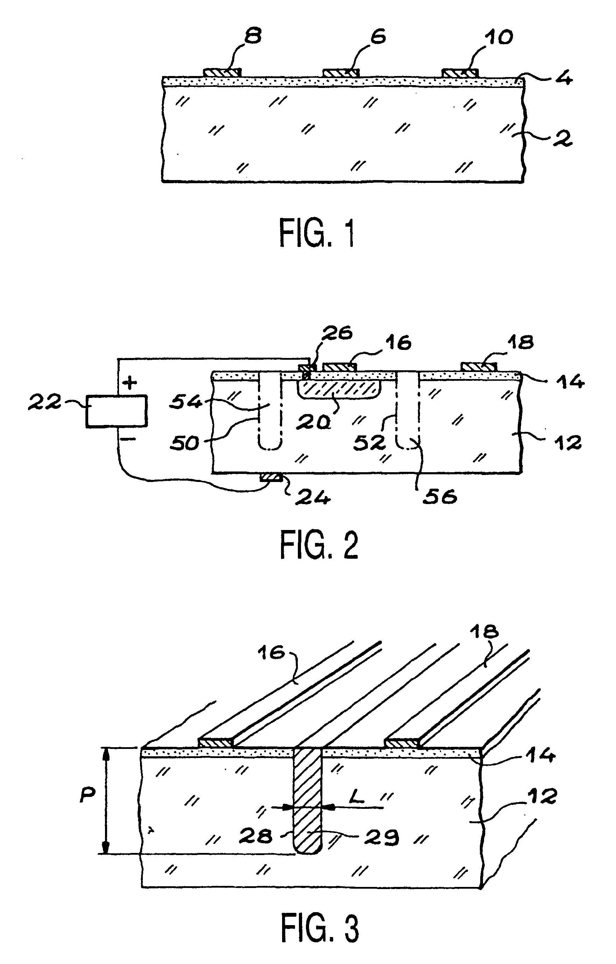

Cette solution est schématiquement illustrée en coupe transversale sur la figure 1 où l'on voit un substrat de silicium 2 recouvert d'une mince couche de silice 4 sur laquelle se trouve la connexion perturbatrice 6 et les deux lignes conductrices 8 et 10.

A ce sujet, on se reportera aussi à l'article de K. Joardar, « Signal isolation in BiCMOS mixed mode integrated circuits », 1995, IEEE, page 178.

La solution connue n'offre qu'une protection partielle : elle n'empêche pas le couplage électromagnétique entre la connexion perturbatrice 6 et d'autres connexions ou composants non représentés, également formés sur le substrat 2.

De plus, cette solution connue ne permet pas d'isoler correctement la connexion perturbatrice 6, dans le domaine des fréquences millimétriques et des hyperfréquences, vis-à-vis de ces autres connexions ou composants : entre ces derniers et la connexion perturbatrice 6, des signaux à ces fréquences sont susceptibles d'être échangés par l'intermédiaire du substrat 2.

US-A-5 151 770 décrit un dispositif semiconducteur pouvant opérer dans la bande de fréquences des micro-ondes et incluant des moyens de blindage isolant un circuit intégré d'autres circuits intégrés. Les moyens de blindage sont formés par des techniques de fabrication de circuits intégrés.

US-A-5 831 324 décrit un dispositif comprenant un transistor NPN formé sur un substrat. Une tranchée isolante, qui s'étend dans le substrat, entoure le transistor NPN. Dans la tranchée isolante se trouve une région comprenant un matériau dont la résistance électrique croit avec la fréquence. Cette région constitue un écran électromagnétique empêchant la propagation d'ondes électromagnétiques le long de la surface du substrat.

### EXPOSÉ DE L'INVENTION

La présente invention a pour but de remédier aux inconvénients précédents.

La revendication 1 définit un dispositif semiconducteur selon l'invention. Les revendications dépendantes définissent des modes de réalisation avantageux.

L'élément électrique ou électronique concerné peut être aussi bien une connexion électrique qu'un composant électrique ou électronique ou un circuit intégré ou une portion d'un tel circuit ou même une zone qui est intégrée au substrat et délimitée par le dispositif et dans laquelle des signaux dans le domaine des fréquences millimétriques, des radiofréquences ou des hyperfréquences sont capables de se propager, le dispositif formant alors aussi un support de propagation intégré (qui est en quelque sorte autoprotégé).

### BRÈVE DESCRIPTION DES DESSINS

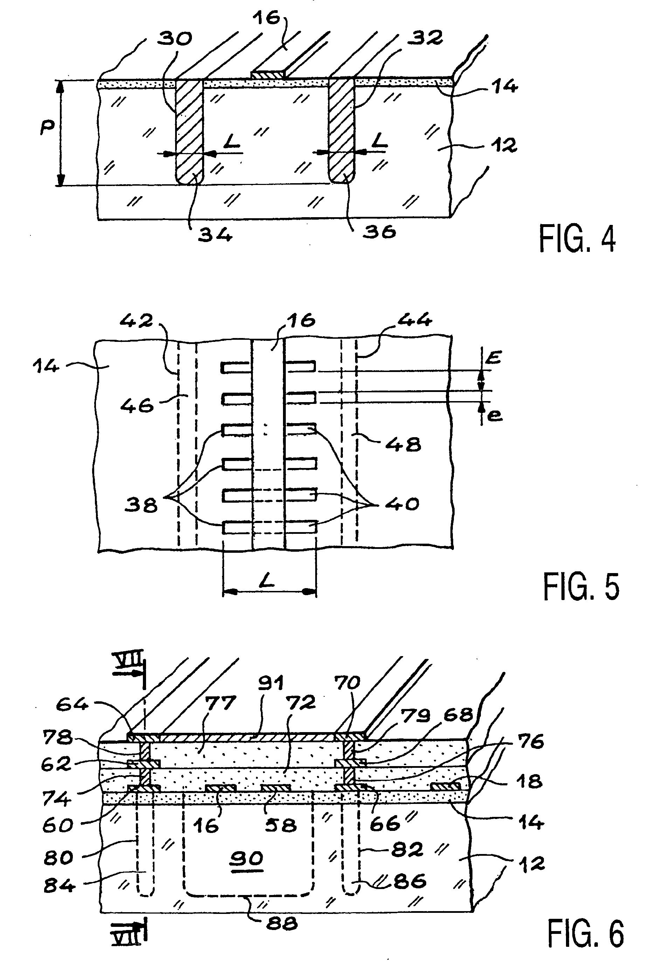

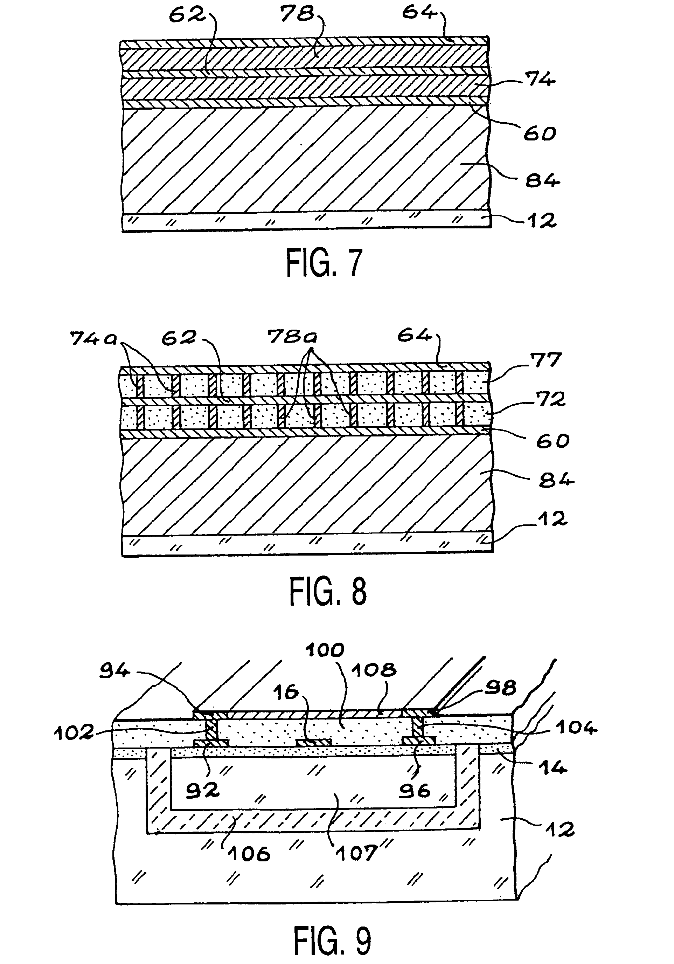

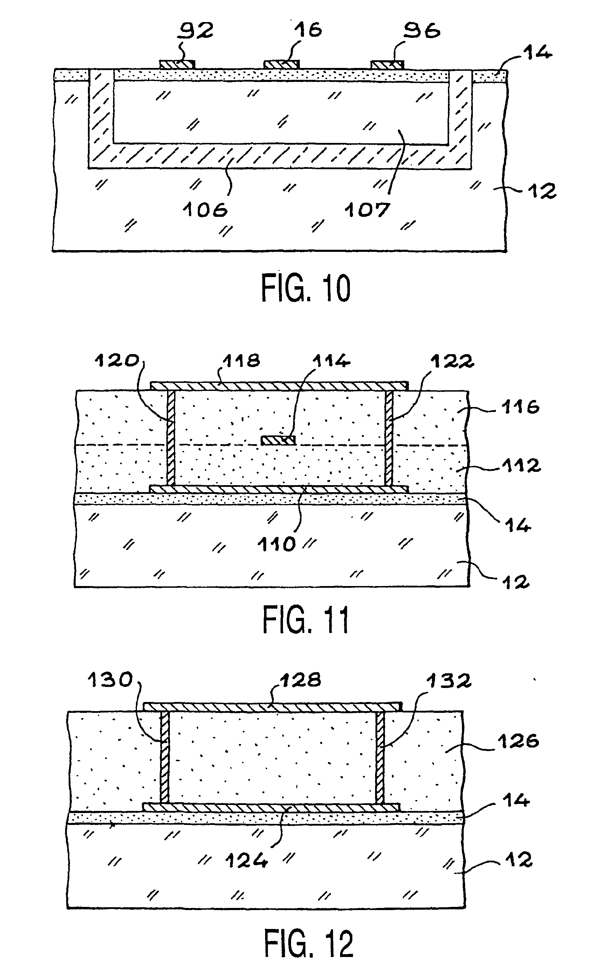

La présente invention sera mieux comprise à la lecture de la description d'exemples de réalisation donnés ci-après, à titre purement indicatif et nullement limitatif, en faisant référence aux dessins annexés sur lesquels .
■ la figure 1 est une vue en coupe transversale schématique d'un dispositif connu, destiné à l'isolation d'une connexion perturbatrice, et a déjà été décrite,
■ la figure 2 est une vue en coupe transversale schématique d'un mode de réalisation d'un isolation de signaux électriques
■ la figure 3 illustre de façon schématique et partielle un autre mode de réalisation d'un isolation de signaux électriques
■ la figure 4 illustre de façon schématique et partielle une variante du dispositif de la figure 3,
■ la figure 5 est une vue de dessus schématique et partielle d'un mode de réalisation particulier du dispositif objet de l'invention,
■ la figure 6 illustre de façon schématique et partielle un autre mode de réalisation particulier du dispositif objet de l'invention,
■ la figure 7 est la coupe VII-VII de la figure 6,
■ la figure 8 illustre schématiquement une variante de la figure 7,
■ la figure 9 illustre de façon schématique et partielle un mode de réalisation
■ la figure 10 est une vue en coupe transversale schématique d'un mode de réalisation d'un isolation de signaux électriques,
■ la figure 11 est une vue en coupe transversale schématique d'un dispositif d'un isolation de signaux électriques , formant aussi une structure « triplaque »,
■ la figure 12 est une vue en coupe transversale schématique d'un dispositif d'un isolation de signaux électriques , formant aussi un guide d'onde.

### EXPOSÉ DÉTAILLÉ DE MODES DE RÉALISATION PARTICULIERS

Un exemple d'un isolation de signaux électriques est schématiquement illustré par la figure 2 où l'on voit un substrat semiconducteur 12 qui est par exemple en silicium de type P. Ce substrat est recouvert d'une mince couche électriquement isolante 14 qui est par exemple en silice et dont l'épaisseur est inférieure à 10µm par exemple. L'élément que l'on veut isoler est une ligne conductrice 16 formée sur la couche isolante 14.

On souhaite par exemple isoler la ligne conductrice 16 d'une autre ligne conductrice 18 qui est parallèle à la ligne 16 et également formée sur la couche isolante 14.

On utilise pour ce faire une couche d'isolation qui, dans l'exemple de la figure 2, est une couche semiconductrice enterrée 20 de type N que l'on obtient par diffusion dans le substrat avant de former la couche 14. Cette couche 20 s'étend sous la ligne conductrice 16 et a une largeur supérieure à la largeur de cette ligne 16 comme on le voit sur la figure 2.

Une source de tension continue 22 est prévue pour polariser de façon inverse la jonction PN formée par la courbe 20 et le substrat : le pôle - de la source 22 est relié au substrat 12 par l'intermédiaire d'un contact électrique 24 et le pôle + de cette source 22 est relié à la couche enterrée 20 par l'intermédiaire d'une traversée 26 (« via » dans les articles en langue anglaise) à travers la couche isolante 14.

On obtient ainsi une isolation capacitive de la ligne conductrice 16.

Si le substrat 12 est fait d'un matériau semiconducteur de type N, on forme une couche enterrée 20 de type P et l'on utilise une source de tension continue dont le pôle - est relié à cette couche enterrée de type P et dont le pôle + est relié au substrat.

Un autre exemple de d'un isolation de signaux électriques est schématiquement illustré par la figure 3 où l'on voit encore le substrat semiconducteur 12 à la surface duquel est formée la mince couche isolante 14. On voit aussi les lignes conductrices 16 et 18 que l'on veut isoler l'une de l'autre.

Pour ce faire, on forme une tranchée profonde 28 parallèle aux lignes 16 et 18 et comprise entre ces dernières. Cette tranchée est formée dans le substrat 12 à travers la couche isolante 14 et a une profondeur P par exemple égale à 6µm et une largeur L par exemple égale à 2µm.

Après avoir formé la tranchée 28, cette dernière est remplie d'une couche d'isolation 29 qui peut être faite d'un matériau électriquement isolant ou conducteur ou semiconducteur.

Un autre exemple d'un isolation de signaux électriques est schématiquement illustré par la figure 4 où l'on voit encore la ligne conductrice 16. On n'a pas représenté l'autre ligne conductrice 18 ni les éventuels autres éléments que l'on veut isoler de la ligne conductrice 16.

On voit sur la figure 4 deux tranchées profondes 30 et 32 parallèles l'une à l'autre ainsi qu'à la ligne conductrice 16 et s'étendant respectivement des deux côtés de cette dernière. Ces deux tranchées sont encore formées dans le substrat 12 à travers la couche isolante 14.

La profondeur P et la largeur L de ces tranchées peuvent avoir, par exemple, les valeurs données plus haut.

Après avoir été formées, ces tranchées sont respectivement remplies de couches d'isolation 34 et 36 qui peuvent être faites d'un matériau électriquement isolant ou conducteur ou semiconducteur.

Un exemple de l'invention est schématiquement illustré par la figure 5 où l'on voit encore la ligne conductrice 16 formée sur la mince couche isolante 14 qui recouvre le substrat 12 (non représenté sur la figure 5).

Plusieurs tranchées parallèles et profondes 38 s'étendent dans ce substrat, perpendiculairement à la surface de celui-ci, à travers la couche 14, et sous la ligne conductrice 16. De plus, comme on le voit, ces tranchées sont perpendiculaires à cette ligne 16.

Chaque tranchée 38 est remplie d'une couche d'isolation 40. De plus, chaque tranchée a une largeur L qui est supérieure à la largeur de la piste conductrice 16 et vaut par exemple 20µm ; l'espace E entre deux tranchées adjacentes 38 vaut par exemple 2µm ; la profondeur des tranchées 38 vaut par exemple 6µm et la longueur ou épaisseur e des tranchées 38 vaut par exemple 2µm.

On forme d'abord les tranchées 38 dans le substrat 12, à travers la couche isolante 14, et l'on remplit chacune de ces tranchées d'une couche d'isolation 40 puis on forme la ligne conductrice 16.

Les tranchées 38, remplies chacune d'une couche d'isolation 40, permettent d'éviter la formation de courants longitudinaux dans le substrat 12.

Dans un autre exemple de l'invention (voir aussi la figure 5), en plus des tranchées transversales 38, on prévoit deux tranchées longitudinales 42 et 44 remplies de couches d'isolation 46 et 48 et respectivement disposées de part et d'autre de l'ensemble des tranchées 38. Ces tranchées 42 et 44 sont du même genre que les tranchées 34 et 36 de la figure 4. Elles s'étendent le long de la ligne conductrice 16 et permettent de renforcer l'isolation de cette dernière. A cet effet, on pourra également réaliser des tranchées longitudinales profondes dans le substrat pour relier électriquement entre elles les tranchées transversales 38 et former ainsi une grille équipotentielle sous la ligne conductrice 16.

Dans un exemple d'in isolation de signaux électriques (voir la figure 2), on prévoit deux tranchées longitudinales 50 et 52 parallèles à la piste conductrice 16 et s'étendant respectivement de chaque côté de la couche enterrée 26. Ces tranchées 50 et 52, remplies de couches d'isolation 54 et 56, permettent aussi d'augmenter l'isolation de la ligne conductrice 16 de la figure 2.

Les couches d'isolation qui remplissent les tranchées (que ces tranchées s'étendent le long de l'élément que l'on veut isoler ou transversalement à cet élément) peuvent être faites d'un polysilicium à faible résistivité ou d'un matériau électriquement isolant tel la silice, par exemple.

Dans le cas où les tranchées s'étendent le long de l'élément que l'on veut isoler sans être en contact avec cet élément, on peut utiliser un matériau électriquement conducteur, par exemple du polysilicium à faible résistivité, pour former les couches d'isolation qui remplissent ces tranchées.

Dans l'exemple de l'invention qui est schématiquement illustré par la figure 6, pour isoler un élément tel que la ligne conductrice 16 formée sur la couche isolante 14 qui recouvre le substrat 12, on utilise un groupe d'au moins deux (trois dans l'exemple de la figure 6) conducteurs électriques superposés de chaque côté de la ligne conductrice 16. Ces conducteurs électriques sont intégrés au substrat 12 et s'étendent le long de la ligne conductrice 16.

La hauteur de chaque groupe est supérieure à celle de la ligne 16.

Il convient de noter que l'on peut isoler, conformément à l'invention, non pas un seul élément mais une pluralité d'éléments, par exemple deux lignes conductrices parallèles, comme le montre la figure 6, à savoir la ligne conductrice 16 et une autre ligne conductrice 58 qui est formée sur la couche 14 et parallèle à la ligne 16 et qui est aussi comprise dans la zone délimitée par les deux groupes de conducteurs superposés, la hauteur de ces groupes étant supérieure à celle de la ligne 16.

En allant de bas en haut à partir de la couche 14, les conducteurs superposés ont les références 60, 62 et 64 d'un côté des lignes 16 et 58 que l'on veut isoler et les références 66, 68 et 70 de l'autre côté.

On voit que les conducteurs superposés sont électriquement reliés les uns aux autres par des traversées (« vias ») formées à travers un matériau électriquement isolant comme par exemple la silice.

Les conducteurs 60 et 66 sont d'abord formés sur la couche de silice 14. On forme alors, sur cette dernière, une couche de silice 72 qui recouvre ces conducteurs 60 et 66 ainsi que les lignes conductrices 16 et 58 puis on forme à travers cette couche 72 deux traversées continues 74 et 76 (voir la figure 7) qui s'étendent respectivement sur les conducteurs 60 et 66 en traversant cette couche 72.

On forme ensuite, à la surface de cette couche 72, les conducteurs 62 et 68 qui sont en contact respectivement avec les couches 60 et 66 par l'intermédiaire des traversées 74 et 76. On forme ensuite, sur la couche 72, une couche de silice 77 qui recouvre ces conducteurs 62 et 68 puis on forme à travers cette couche 77 deux traversées 78 et 79 qui sont respectivement en contact avec ces conducteurs 62 et 68.

On forme ensuite, à la surface de cette couche 73, les conducteurs 64 et 70 qui sont respectivement en contact avec les conducteurs 62 et 68 par l'intermédiaire des traversées 78 et 79.

En variante, au lieu d'utiliser des traversées continues pour relier deux conducteurs superposés adjacents (voir la figure 7), on peut utiliser plusieurs traversées discrètes, telles que l'ensemble de traversées 74a ou l'ensemble de traversées 78a (voir la figure 8) qui relient ces deux conducteurs à travers la couche isolante séparant ces derniers.

Les traversées 74a et 78a de la figure 8 ont sensiblement la forme de fils et l'espacement entre ces fils est choisi en fonction de la fréquence des signaux électriques que l'on veut isoler.

Dans un autre exemple de l'invention, on peut prévoir deux tranchées 80 et 82 (voir figure 6), du genre des tranchées 30 et 32 de la figure 4, respectivement sous les conducteurs 60 et 66. Ces tranchées sont remplies de couches d'isolations 84 et 86 qui peuvent être faites d'un matériau électriquement isolant ou au contraire électriquement conducteur puisque ce matériau est en contact avec les conducteurs 60 et 66.

En plus des tranchées 80 et 82 ou en l'absence de ces dernières, on peut aussi prévoir des tranchées transversales 88 du genre des tranchées 38 de la figure 5. Ces tranchées 88 s'étendent sous les éléments que l'on veut isoler, comme on le voit sur la figure 6, et sont remplies de couches d'isolation 90 faites d'un matériau électriquement isolant.

On peut aussi prévoir, sur la couche isolante 77, une couche électriquement conductrice 91 qui s'étend au-dessus des éléments à isoler (lignes 16 et 58) et relie les deux conducteurs les plus hauts 64 et 70 qui sont respectivement disposés des deux côtés de ces éléments de manière à constituer un blindage électromagnétique intégré.

Un autre exemple d'un isolation de signaux électriques est schématiquement illustré par la figure 9 où l'on voit la ligne conductrice 16 que l'on veut isoler. De part et d'autre de cette ligne 16 et le long de cette dernière, sont prévus deux couples de conducteurs électriques 92-94 et 96-98. Les conducteurs 92 et 96 sont formés sur la couche de silice 14. Une autre couche de silice 100 est formée sur la couche 14 et recouvre les conducteurs 92 et 96 ainsi que la ligne conductrice 16.

Les conducteurs 94 et 98 sont formés sur cette couche 100 et des traversées 102 et 104, qui peuvent être continues (comme dans l'exemple de la figure 7) ou discontinues (comme dans l'exemple de la figure 8), relient respectivement les conducteurs 92 et 94 et les conducteurs 96 et 98 à travers la couche 100.

En outre, une couche d'isolation 106 s'étend sous les conducteurs 92 et 96 et sous la ligne conductrice 16 et remonte jusqu'à la surface de la couche 14 du côté du conducteur 92 et aussi du côté du conducteur 96 pour isoler ainsi une zone 107 du substrat où est formée la ligne 16.

On pourra utiliser un matériau isolant pour former la couche 106 et l'on procèdera alors de la façon suivante : le substrat de silicium comprenant initialement une mince couche d'oxyde enterrée, des tranches remplies d'oxyde seront ajoutées de sorte qu'elles soient en contact avec ladite couche d'oxyde, formant alors un caisson d'isolation.

Pour obtenir une isolation optimale contre les effets de signaux haute fréquence, la couche d'isolation supplémentaire 106 peut être réalisée par diffusion profonde dans le substrat 12 et la couche isolante 14 : si le substrat est de type P (respectivement N) on utilise une couche enterrée 106 de type N (respectivement P).

On peut aussi prévoir une couche conductrice 108 formée à la surface de la couche de silice 100, au-dessus du conducteur 16, et reliant les conducteurs rectilignes 94 et 98.

Un autre exemple d'un isolation de signaux électriques est schématiquement illustré par la figure 10. Le dispositif d'isolation que l'on voit sue cette figure 10 est plus simple que celui de la figure 9. Dans le cas de la figure 10, on utilise simplement les conducteurs 92 et 96 ainsi que la couche d'isolation 106 qui isole la portion 107 du substrat 12.

En choisissant judicieusement les dimensions d'un dispositif d'un isolation de signaux électriques on peut obtenir un support de propagation intégré qui est compatible avec les hyperfréquences (figure 11) et même un guide d'onde intégré pour les fréquences millimétriques (figure 12).

Sur la figure 11, on voit le substrat 12 encore recouvert de la couche de silice 14. Une couche conductrice 110, par exemple en polysilicium à faible résistivité, est formée sur cette couche 14.

Une couche isolante 112 par exemple en silice recouvre cette couche conductrice 110 et l'on forme un conducteur rectiligne 114 sur cette couche isolante 112. Ce conducteur 114 s'étend au-dessus et le long de la couche conductrice 110.

On recouvre la couche isolante 112 et ce conducteur 114 d'une autre couche isolante en silice 116. On forme alors, sur la couche formée par la réunion de ces deux couches isolantes 112 et 116, une autre couche conductrice 118 sensiblement identique à la couche 110 et s'étendant au-dessus de cette dernière.

Ainsi le conducteur 114 se trouve-t-il compris entre ces deux couches conductrices 110 et 118 tout en étant isolé de ces dernières, d'où une structure « triplaque ».

Suivant la fréquence des signaux que l'on veut transmettre par l'intermédiaire de cette structure, on peut prévoir ou non des traversées 120 et 122 (de préférence deux traversées continues) respectivement placées de part et d'autre du conducteur 114 et reliant les couches conductrices 110 et 120 à travers les couches isolantes 112 et 116. Les couches conductrices 110 et 118, ainsi que les traversées 120 et 122 seront avantageusement connectées à une même borne de référence de potentiel.

Les signaux transportés par cette structure « triplaque » sont ainsi isolés, l'invention, d'autres signaux électriques transportés dans d'autres éléments également formés sur le substrat 12, à l'extérieur de la structure « triplaque ».

Un autre exemple d'un isolation de signaux électriques est schématiquement illustré par la figure 12 où l'on voit encore le substrat semiconducteur 12 recouvert de la couche de silice 14. Une couche conductrice 124 est formée sur cette couche de silice 14.

Une couche isolante 126, par exemple en silice, recouvre cette couche conductrice 124. Une autre couche conductrice 128 est formée à la surface de cette couche isolante 126, au-dessus de la couche conductrice 124, et l'on relie, à travers la couche isolante 126, ces couches conductrices 124 et 128 par l'intermédiaire de traversées 130 et 132 (de préférence deux traversées continues). Les couches conductrices 124 et 128, ainsi que les traversées 130 et 132 seront avantageusement connectées à une même borne de référence de potentiel.

On forme ainsi un support de propagation du genre guide d'onde.

Les signaux électriques, qui sont transportés par ce guide d'onde (dans la zone isolante 134 délimitée par les couches conductrices 124 et 128 et les traversées 130 et 132) et ont des fréquences millimétriques, sont alors isolés de signaux électriques se propageant dans d'autres élément formés sur le substrat 12 (à l'extérieur du guide d'onde).

On précise que les conducteurs, les lignes ou pistes conductrices et les couches conductrices, dont il a été question plus haut, sont par exemple faites d'un métal tel l'aluminium.

Les traversées (« vias ») utilisent par exemple un métal tel le tungstène.

De plus, seul l'exemple de la figure 2 utilise une source de polarisation. Cependant, on pourra avantageusement utiliser une telle source lorsqu'une couche isolante obtenue par diffusion de type N ou P est utilisée.

Dans les exemples des figures 2 à 10, on utilise une couche isolante à la surface du substrat semiconducteur. Cependant, on pourrait supprimer ladite couche dans le cas des exemples décrits par les figures 11 et 12.

De plus, les exemples des figures 2 à 10 s'appliquent à l'isolation d'une ou d'une pluralité de pistes conductrices. Cependant, ces exemples pourraient aussi permettre d'isoler par exemple des portions de circuit sensibles à des perturbations électromagnétiques externes.

## Revendications

1. Dispositif semiconducteur comprenant :
- un substrat semiconducteur (12) muni d'un élément électrique ou électronique (16, 58) ayant un axe longitudinal ; le dispositif étant **caractérisé en ce qu'**il comprend:
- plusieurs tranchées transversales (38) qui s'étendent dans le substrat semiconducteur, les tranchées transversales étant disposées en parallèle, perpendiculairement à la surface du substrat semiconducteur, sous l'élément et transversalement à l'axe longitudinal de l'élément, chaque tranchée transversale étant remplie d'une couche d'isolation (40).

2. Dispositif selon la revendication 1, comprenant :
- un ensemble dont la hauteur est supérieure à celle de l'élément et qui comprend, de chaque côté de l'axe longitudinal de l'élément, un groupe d'au moins deux conducteurs électriques superposés (60-62-64, 66-68-70), disposé sur le substrat semiconducteur et s'étendant le long de l'axe longitudinal de l'élément.

3. Dispositif selon la revendication 1, comprenant en outre au moins une tranchée longitudinale (42-44, 80-82) s'étendant dans le substrat semiconducteur (12), perpendiculairement à la surface du substrat semiconducteur et le long de l'axe longitudinal de l'élément (16, 58), la tranchée longitudinale étant disposée entre l'élément et un autre élément électrique ou électronique (18), et étant remplie d'une couche d'isolation.

4. Dispositif selon la revendication 3, comprenant deux tranchées longitudinales (42-44, 80-82) s'étendant dans le substrat semiconducteur (12), perpendiculairement à la surface de ce substrat et le long de l'axe longitudinal de l'élément (16, 58), respectivement de chaque côté de l'axe longitudinal de cet élément.

5. Dispositif selon la revendication 4, dans lequel chaque tranchée longitudinale (80, 82) s'étend sous un groupe d'au moins deux conducteurs électriques superposés (60-62-64, 66-68-70).

6. Dispositif selon l'une quelconque des revendications 2 ou 5, dans lequel les conducteurs électriques superposés (60-62-64) d'un groupe sont électriquement reliés l'un à l'autre par au moins une traversée (74-78, 74a-78a, 76-79) formée à travers un matériau électriquement isolant (72, 77).

7. Dispositif selon la revendication 6, dans lequel chaque traversée (74, 78) s'étend d'une extrémité à l'autre du groupe de conducteurs électriques superposés (60-62-64).

8. Dispositif selon la revendication 6, dans lequel les conducteurs électriques superposés (60-62-64) du groupe sont reliés par l'intermédiaire de plusieurs traversées (74a, 78a) espacées les unes des autres.

9. Dispositif selon l'une quelconque des revendications 2 ou 5, comprenant en outre une couche électriquement conductrice (91) qui s'étend au-dessus de l'élément et relie le conducteur électrique le plus haut (64) du groupe disposé à un côté de l'axe longitudinal au conducteur électrique le plus haut (70) du groupe disposé à l'autre côté de élément.

10. Circuit de communication intégré comprenant un dispositif selon l'une quelconque des revendications précédentes.

## Claims

1. A semiconductor device comprising:
- a semiconductor substrate (12) comprising an electric or electronic element (16, 58) having a longitudinal axis; the device being **characterized in that** it comprises:
- various transverse trenches (38) which extend into the semiconductor substrate, the transverse trenches being disposed in parallel, at right angles to the surface of the semiconductor substrate underneath the element and transversely to the longitudinal axis of the element, each transverse trench being filled with an isolation layer (40).

2. A device as claimed in claim 1, comprising:
- an assembly whose height exceeds that of the element and which includes on either side of the longitudinal axis of the element a group of at least two superposed electric conductors (60-62-64, 66, 68, 70) disposed on the semiconductor substrate and extending along the longitudinal axis of the element.

3. A device as claimed in claim 1, further comprising at least a longitudinal trench (42-44, 80-82) which extends into the semiconductor substrate (12) at right angles to the surface of the semiconductor substrate and along the longitudinal axis of the element (16, 58), the longitudinal trench being disposed between the element and another electric or electronic element (18) and being filled with an isolation layer.

4. A device as claimed in claim 3, comprising two longitudinal trenches (42-44, 80-82) which extend into the semiconductor substrate (12) at right angles to the surface of this substrate and along the longitudinal axis of the element (16, 58), on either side of the longitudinal axis of this element.

5. A device as claimed in claim 4, wherein each longitudinal trench (80, 82) extends underneath a group of at least two superposed electric conductors (60-62-64, 66-68-70).

6. A device as claimed in any one of the claims 2 or 5, wherein the superposed electric conductors (60-62-64) of a group are electrically interconnected by means of at least one via (74-78, 74a-78a, 76-79) formed through an electrically insulating material (72, 77).

7. A device as claimed in claim 6, wherein each via (74, 78) extends from one end to the other end of the group of superposed electric conductors (60-62-64).

8. A device as claimed in claim 6, wherein the superposed electric conductors (60-62-64) of the group are interconnected by means of a number of vias (74a, 78a) which are spaced apart.

9. A device as claimed in any one of the claims 2 or 5, additionally including an electrically conducting layer (91) which extends above the element and connects the uppermost electric conductor (64) of the group disposed on one side of the longitudinal axis to the uppermost electric conductor (70) of the group disposed on the other side of the element.

10. An integrated communication circuit comprising a device as claimed in any one of the preceding claims.

## Patentansprüche

1. Halbleitervorrichtung, die umfasst:
- ein Halbleitersubstrat (12), das mit einem elektrischen oder elektronischen Element (16, 58) versehen ist, das eine Längsachse besitzt; wobei die Vorrichtung **dadurch gekennzeichnet ist, dass** sie umfasst:
- mehrere transversale Einschnitte (38), die sich im Halbleitersubstrat erstrecken, wobei die transversalen Einschnitte parallel und senkrecht zur Oberfläche des Halbleitersubstrats unter dem Element und quer zur Längsachse des Elements angeordnet sind, wobei jeder transversale Einschnitt mit einer Isolierschicht (40) gefüllt ist.

2. Vorrichtung nach Anspruch 1, die umfasst:
- eine Anordnung, deren Höhe größer ist als jene des Elements und die auf jeder Seite der Längsachse des Elements eine Gruppe aus wenigstens zwei übereinander liegenden elektrischen Leitern (60-62-64, 66-68-70) umfasst, die auf dem Halbleitersubstrat angeordnet ist und sich in Richtung der Längsachse des Elements erstreckt.

3. Vorrichtung nach Anspruch 1, die außerdem wenigstens einen longitudinalen Einschnitt (42-44, 80-82) umfasst, der sich im Halbleitersubstrat (12) senkrecht zu der Oberfläche des Halbleitersubstrats und in Richtung der Längsachse des Elements (16, 58) erstreckt, wobei der longitudinale Einschnitt zwischen dem Element und einem weiteren elektrischen oder elektronischen Element (18) angeordnet ist und mit einer Isolierschicht gefüllt ist.

4. Vorrichtung nach Anspruch 3, die zwei longitudinale Einschnitte (42-44, 80-82) umfasst, die sich im Halbleitersubstrat (12) senkrecht zur Oberfläche dieses Substrats und in Richtung der Längsachse des Elements (16, 58) jeweils auf einer Seite der Längsachse dieses Elements erstrecken.

5. Vorrichtung nach Anspruch 4, in der sich jeder longitudinale Einschnitt (80, 82) unter einer Gruppe aus wenigstens zwei übereinander liegenden elektrischen Leitern (60-62-64, 66-68-70) erstreckt.

6. Vorrichtung nach einem der Ansprüche 2 oder 5, in der die übereinander liegenden elektrischen Leiter (60-62-64) einer Gruppe miteinander über wenigstens eine Durchführung (74-78, 74a-78a, 76-79), die durch ein elektrisch isolierendes Material (72, 77) hindurch gebildet ist, elektrisch verbunden sind.

7. Vorrichtung nach Anspruch 6, wobei sich jede Durchführung (74, 78) von einem Ende zum anderen Ende der Gruppe aus übereinander liegenden elektrischen Leitern (60-62-64) erstreckt.

8. Vorrichtung nach Anspruch 6, in der die übereinander liegenden elektrischen Leiter (60-62-64) der Gruppe über mehrere Durchführungen (74a, 78a), die voneinander beabstandet sind, verbunden sind.

9. Vorrichtung nach einem der Ansprüche 2 oder 5, die außerdem eine elektrisch leitende Schicht (91) umfasst, die sich über dem Element erstreckt und den höchsten elektrischen Leiter (64) der Gruppe, der auf einer Seite der Längsachse angeordnet ist, mit dem höchsten elektrischen Leiter (70) der Gruppe, der auf der anderen Seite des Elements angeordnet ist, verbindet.

10. Integrierte Kommunikationsschaltung, die eine Vorrichtung nach einem der vorhergehenden Ansprüche umfasst.
